# EUROPEAN PATENT APPLICATION

(11) **EP 4 468 604 A1**
(43) Date of publication of application: **27.11.2024**
(21) Application number: 23174433.5
(22) Date of filing: 22.05.2023
(51) Int. Cl.: H03K 4/02, H02M 3/07, H03K 3/03

(54) **HIGH VOLTAGE ARBITRARY WAVEFORM GENERATOR**

(71) Applicant: ECOLE POLYTECHNIQUE FEDERALE DE LAUSANNE (EPFL), 1015 Lausanne (CH)
(72) Inventor: CHARBON, Edoardo, 1008 Jouxtens-Mézery (CH); YILDIRIM, Halil Kerim, 2000 Neuchâtel (CH)
(74) Representative: e-Patent SA

(57) **Abstract**

High voltage arbitrary waveform generator (1) comprising:
- a voltage-controlled oscillator (3) arranged to output a clock signal *(CLK)* and an inverted clock signal (*C̅L̅K̅*) at a frequency determined by at least one control voltage (*V_{ctrl_a⁻}*, *V*_{*ctrl_a*⁺}, *V*_{*ctrl*_{d}<5:0>});
- a first charge pump (7) arranged to receive said clock signal *(CLK)* and said inverted clock signal (*C̅L̅K̅*) and to increase an output voltage (*Vₒᵤₜ*) at an output node (10) in response to said clock signal *(CLK)* and said inverted clock signal (*C̅L̅K̅*);
- a second charge pump (9) arranged to receive said clock signal *(CLK)* and said inverted clock signal (*C̅L̅K̅*) and to decrease said output voltage (*Vₒᵤₜ*) at said output node (10) in response to said clock signal *(CLK)* and said inverted clock signal (*C̅L̅K̅*);
- a selector adapted transmit said clock signal *(CLK)* and said inverted clock signal (*C̅L̅K̅*) to either said first charge pump (7) or said second charge (9) pump at any given time in response to a select signal (*Select*);
- a load (*C_{L}*) connected between said output node (10) and ground.

## Description

### Technical Field

The present invention relates to the field of waveform generation. More particularly, it relates to a high voltage arbitrary waveform generator based on a voltage-controlled oscillator and a charge pump. Potential uses for this waveform generator include frequency-modulated continuous wave (FMCW) LiDAR applications, ultrasound transducers, piezoactuators, neurostimulators, and many other devices.

### State of the Art

Y. Ismail and C. -K. K. Yang, "A 12-V charge pump-based square wave driver in 65-nm CMOS technology," 2014 IEEE Asian Solid-State Circuits Conference (A-SSCC), KaoHsiung, Taiwan, 2014, pp. 237-240, doi: 10.1109/ASSCC.2014.7008904 describes a high-voltage output stage producing square wave signals well beyond the voltage ratings of standard devices in a nanometer-scale CMOS technology.

H. -K. Cha, D. Zhao, J. H. Cheong, B. Guo, H. Yu and M. Je, "A CMOS High-Voltage Transmitter IC for Ultrasound Medical Imaging Applications," in IEEE Transactions on Circuits and Systems II: Express Briefs, vol. 60, no. 6, pp. 316-320, June 2013, doi: 10.1109/TCSII.2013.2258260 describes a device for providing over 10 Volt peak-to-peak pulses at 1.25 MHz frequency for ultrasound medical imaging applications.

However, neither of these systems, or ones similar thereto, are capable of generating arbitrary waveforms at high voltages, i.e. waveforms with any desired shape.

The aim of the present invention is hence to propose a high voltage arbitrary waveform generator which at least partially overcomes the limitations of the prior art.

### Disclosure of the invention

More specifically, the invention relates to a high voltage arbitrary waveform generator (AWG) as defined in claim 1. In the context of the invention, "high voltage" means a voltage greater than that of the supply voltage.

This AWG comprises:
- a voltage-controlled oscillator, i.e. an oscillator whose frequency can be varied by adjusting at least one control voltage, arranged to output a clock signal and an inverted clock signal at a frequency determined by at least one control voltage;
- a first charge pump arranged to receive said clock signal and said inverted clock signal and to increase an output voltage at an output node in response to said clock signal and said inverted clock signal;
- a second charge pump arranged to receive said clock signal and said inverted clock signal and to decrease said output voltage at said output node in response to said clock signal and said inverted clock signal;
- a selector adapted transmit said clock signal and said inverted clock signal to either said first charge pump or said second charge pump at any given time in response to a select signal;
- a load connected between said output node and ground (i.e. a ground voltage). This load can be any impedance driven by the AWG.

By varying the at least one control voltage of the voltage-controlled ring oscillator, the rate of output voltage ramp-up or ramp-down can be varied, the "select" signal determining which charge pump is active and hence whether the output voltage ramps up (if the first charge pump is receiving the clock signal and the inverted clock signal) or down (if the second charge pump is receiving the clock signal and the inverted clock signal). As a result, a wide variety of shapes of waveforms of output voltage can be generated by varying the rate of output voltage change with the at least one control voltage and whether this change is positive or negative by means of the "select" signal.

Furthermore, due to the use of charge pumps, the output voltage can be significantly higher than the supply voltage.

Advantageously, said voltage-controlled oscillator is a voltage-controlled ring oscillator, preferably a voltage-controlled differential ring oscillator, which may have any number of stages, such as four stages.

Advantageously, at least one of said charge pumps is a Dickson charge pump, which is preferably the case for both of said charge pumps.

Advantageously, said first charge pump comprises 8-13, preferably 11, Dickson charge pump stages, and/or said second charge pump comprises 13-17, preferably 15, Dickson charge pump stages. Different numbers of stages are however possible, according to need. However, the number of stages can be freely determined in function of the desired maximum output voltage.

Advantageously, a discharge transistor arranged to discharge said second charge pump and controlled by said clock signal as transmitted to said second charge pump, a cascode transistor being arranged in series with said discharge transistor and biased by a cascode voltage. This arrangement enables high output voltages to be tolerated, and also permits fewer stages to be used for the second charge pump.

### Brief description of the figures

Further details of the invention will appear more clearly upon reading the following description, in reference to the appended drawing in which:
- Figure 1 is a schematic representation of a high voltage arbitrary waveform generator according to the invention;
- Figure 2 is a schematic representation of an embodiment of a ring oscillator which can be used with the high voltage arbitrary waveform generator of figure 1;
- Figure 3 is a schematic representation of a unit cell of the ring oscillator of figure 2;
- Figure 4 is a schematic representation of an embodiment of a selector which can be used with the high voltage arbitrary waveform generator of figure 1;
- Figure 5 is a schematic partial representation of a first charge pump which can be used with the high voltage arbitrary waveform generator of figure 1;
- Figure 6 a schematic partial representation of a second charge pump which can be used with the high voltage arbitrary waveform generator of figure 1;
- Figure 7 is a graph showing the principle of operation of the high voltage arbitrary waveform generator of figure 1;
- Figure 8 illustrates graphs showing various other waveforms generated by the high voltage arbitrary waveform generator of figure 1; and
- Figure 9 illustrates graphs showing the generation of a particular sawtooth waveform with the high voltage arbitrary waveform generator of figure 1.

### Embodiments of the invention

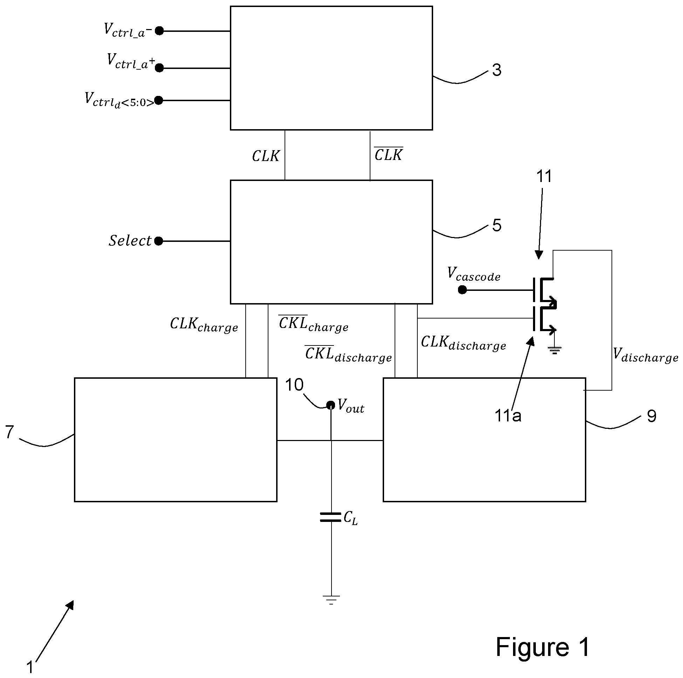

Figure 1 illustrates schematically a high voltage arbitrary waveform generator 1 (abbreviated as "AWG") according to the invention. In the context of the invention, and indeed in the context of such devices more generally, "high voltage" means capable of outputting a voltage which is greater than the supply voltage. Indeed, the AWG 1 described herein can be made in standard 130 nm SiGe BiCMOS technology and can output voltages of up to more than 20 Volts at a supply voltage of 3.3 Volts without suffering from breakdown.

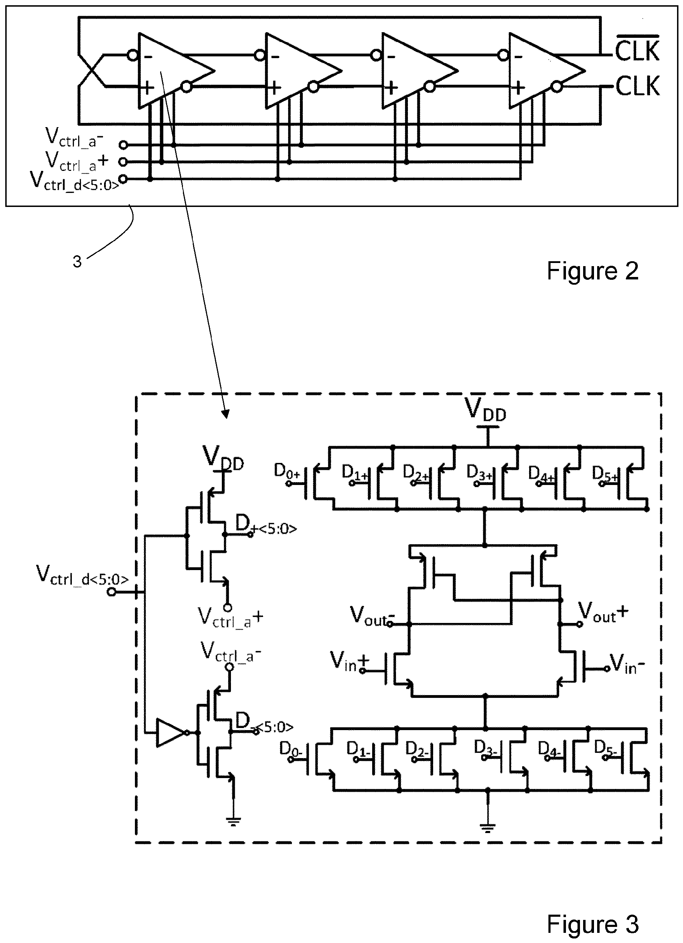

AWG 1 comprises a voltage-controlled oscillator 3, whose frequency of oscillation can be controlled externally by means of at least one control voltage. In the present case, this oscillator 3 is a voltage-controlled ring oscillator 3, which has the control inputs *V_{ctrl_a⁻}*, *V*_{*ctrl_*α⁺} and *V*_{ctrl_{d}}<*5:0*>*,* which will be explained further in the context of figure 2. However, in essence, the inputs are as required for the particular type of oscillator used, in order to control its frequency.

Oscillator 3 outputs a clock signal *CLK* and its inverse *C̅L̅K̅.* These are fed to a selector 5 which passes them selectively to a first charge pump 7 and a second charge pump 9 of any convenient design, which have a common output node 10 with a voltage *Vₒᵤₜ* which is also connected to a load (here illustrated as a load capacitor *C_{L}*, but any type of circuit or device driven by the AWG 1 can also constitute the load) connected between output node 10 and ground. Selector 5 is controlled by an select input *Select,* which causes the signals *CLK* and *C̅L̅K̅* to be passed to either the first charge pump 7, in which case they are designated *CLK_{charge}* and *CKL_{charge}* respectively, or to the second charge pump 9, in which case they are designated *CLK_{discharge}* and *CKL_{discharge}* respectively, however these are simply the signals *CLK* and *C̅L̅K̅* as passed selectively to one or other of the charge pumps 7, 9.

Selector 5 is arranged such that the signals *CLK* and *C̅L̅K̅* are transmitted exclusively to one or other of the charge pumps 7, 9, such that only one of these is active at any given time. First charge pump 7 is arranged to charge the load capacitor *C_{L}*, and hence handles the rising part of the waveform of *Vₒᵤₜ*, whereas second charge pump 9 is arranged to discharge the load capacitor *C_{L}*, and hence handles the falling part of the waveform of *Vₒᵤₜ.*

As a result, the state of the input *Select* determines whether *Vₒᵤₜ* rises or falls, and due to the nature of charge pumps, the frequency of the signals *CLK* and *C̅L̅K̅* determines the rate of change of *Vₒᵤₜ*, i.e. the rate of rise when first charge pump 7 is active, and the rate of fall when second charge pump 9 is active.

The two charge pumps 7, 9 hence operate in a complementary fashion, with *'Select'* signal controlling whether the output voltage *Vₒᵤₜ* increases or decreases. The clocks *CLK* and *C̅L̅K̅* are hence applied only to the charging/discharging charge pump 7, 9 during one half cycle, in which the output voltage rises/falls.

An optional discharge transistor 11a controlled by *CLK_{discharge},* and cascoded by an optional cascode transistor 11 biased by a cascode voltage *V_{cascode}*, is also introduced at *V_{discharge},* which is the final node in the second charge pump 9, so that a voltage up to *2V_{DD}* can be tolerated at this node. This final node can be connected to ground when *CLK_{discharge}* is also active, which allows decreasing the output voltage. This ensures that *Vₒᵤₜ* can safely reach high voltages (such as 20 volts or higher in the case of a 130nm CMOS implementation) without reaching breakdown of the discharge transistors, given that the capacitors and NMOS-to-bulk isolation are within breakdown limits as well. Furthermore, this permits fewer stages to be used for the second charge pump 9 while reaching the same output voltage *Vₒᵤₜ.* Alternatively, the final node in the second charge pump 9 can be grounded, in which case the output voltage would be further limited.

The shape of the waveform of *Vₒᵤₜ* can hence be widely varied, by operating *Select* to determine whether *Vₒᵤₜ* rises or falls, and the control inputs *V*_{*ctrl_a*⁻}, *V*_{*ctrl_*α⁺}+ and *V*_{ctrl_{d}}<5:0> to the ring oscillator 3 to vary the rate of change of *Vₒᵤₜ* in a controlled manner, and thus to cause the voltage *Vₒᵤₜ* to adopt any waveform shape required.

Figure 2 illustrates a particular embodiment of voltage-controlled ring oscillator 3, which is a classic 4-stage differential ring oscillator, outputting the signals *CLK* and *C̅L̅K̅* as described above. The unit cell of the four-stage ring oscillator is as illustrated in figure 3, and has six geometrically sized pairs of NMOS & PMOS loads to control the unit delay. The inputs, *V*_{ctrl_{d}<5.0>}*,* can be digitally switched to turn on a pair of NMOS & PMOS loads each, where *V*_{ctrl_{d}}<5> corresponds to the load with the highest W/L ratio, *V*_{ctrl_{d}}<4>*, V*_{ctrl_{d}}<3>, *v*_{ctrl_{d}}<2>, *v*_{ctrl_{d}}<1> and *V*_{ctrl_{d}}<0> having decreasing W/L ratios, these ratios decreasing geometrically. Using digital inputs, gate voltage of the PMOS loads is connected to *V*_{*ctrl_*α⁺} and the NMOS loads to *V_{ctrl_a⁻}*, respectively. These two gate voltages are controlled differentially in an analog fashion, where their sum equals *V_{DD}*, to fine tune the oscillation frequency. Operating at a supply of 1.2V, the frequency of the ring oscillator 3 outputs *CLK* and *C̅L̅K̅* can be set in the range of 6 MHz to 350 MHz, with a tuning control of 2% at lower frequencies and 0.5% at higher frequencies using 10 mV steps for *V_{ctrl_a⁺}* and *V_{ctrl_a⁻}*. This type of ring oscillator is disclosed in J. Jalil, M. B. I. Reaz and M. A. M. Ali, "CMOS Differential Ring Oscillators: Review of the Performance of CMOS ROs in Communication Systems," in IEEE Microwave Magazine, vol. 14, no. 5, pp. 97-109, July-Aug. 2013, doi: 10.1109/MMM.2013.2259401, hereby incorporated by reference in its entirety.

Of course, other constructions of voltage-controlled oscillators 3 are possible including LC oscillators, single-ended ring oscillators, other differential ring oscillators Examples of such oscillators 3 which can be used in the context of the present invention are disclosed in:
- Wei-Hsuan Tu, Jyh-Yih Yeh, Hung-Chieh Tsai and Chorng-Kuang Wang, "A 1.8V 2.5-5.2 GHz CMOS dual-input two-stage ring VCO," Proceedings of 2004 IEEE Asia-Pacific Conference on Advanced System Integrated Circuits, Fukuoka, Japan, 2004, pp. 134-137, doi: 10.1109/APASIC.2004.1349429.
- C. Li and J. Lin, "A 1-9 GHz Linear-Wide-Tuning-Range Quadrature Ring Oscillator in 130 nm CMOS for Non-Contact Vital Sign Radar Application," in IEEE Microwave and Wireless Components Letters, vol. 20, no. 1, pp. 34-36, Jan. 2010, doi: 10.1109/LMWC.2009.2035961.
- Chan-Hong Park and Beomsup Kim, "A low-noise, 900-MHz VCO in 0.6-/spl mu/m CMOS," in IEEE Journal of Solid- State Circuits, vol. 34, no. 5, pp. 586-591, May 1999, doi: 10.1109/4.760367.
- M. Grazing, B. Phillip and M. Berroth, "CMOS ring oscillator with quadrature outputs and 100 MHz to 3.5 GHz tuning range," ESSCIRC 2004 - 29th European Solid-State Circuits Conference (IEEE Cat. No.03EX705), Estoril, Portugal, 2003, pp. 679-682, doi: 10.1109/ESSCIRC.2003.1257226.
- A. Hajimiri, S. Limotyrakis and T. H. Lee, "Jitter and phase noise in ring oscillators," in IEEE Journal of Solid-State Circuits, vol. 34, no. 6, pp. 790-804, June 1999, doi: 10.1109/4.766813.
- M. Moghavvemi and A. Attaran, "Performance Review of High-Quality-Factor, Low-Noise, and Wideband Radio-Frequency LC-VCO for Wireless Communication [Application Notes]," in IEEE Microwave Magazine, vol. 12, no. 4, pp. 130-146, June 2011, doi: 10.1109/MMM.2011.940602.

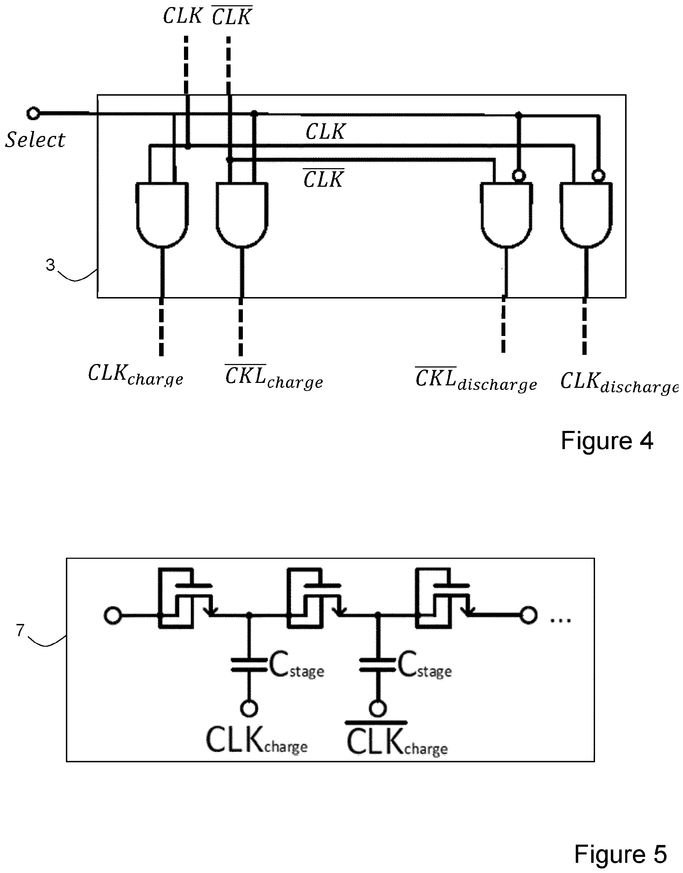

Figure 4 illustrates a particular embodiment of selector 5, which transfers the signals *CLK* and *C̅L̅K̅* to either the first charge pump 7 for augmenting *Vₒᵤₜ* when the value of *Select* is 1, or to the second charge pump 9 to diminish *Vₒᵤₜ* when the value of *Select* is 0. This is achieved by pairs of AND gates arranged in the illustrated fashion.

Figure 5 illustrates a particular embodiment of first charge pump 7, which is an 11-stage charge pump, of which only two and a half stages have been illustrated. This charge pump 7 comprises a plurality of Dickson charge pump stages, implemented with diode connected isolated thick oxide NMOS transistors and metal-insulator-metal (MiM) capacitors, driven by signals *CLK_{charge}* and *CKL_{charge}.* Other types of first charge pump 7 are of course possible including bootstrap, cross coupled, charge transfer switches, and suitable examples are given in:
- G. Palumbo and D. Pappalardo, "Charge Pump Circuits: An Overview on Design Strategies and Topologies," in IEEE Circuits and Systems Magazine, vol. 10, no. 1, pp. 31-45, First Quarter 2010, doi: 10.1109/MCAS.2009.935695.
- A. Umezawa et al., "A 5-V-only operation 0.6- mu m flash EEPROM with row decoder scheme in triple-well structure," in IEEE Journal of Solid-State Circuits, vol. 27, no. 11, pp. 1540-1546, Nov. 1992, doi: 10.1109/4.165334.
- R. Pelliconi, D. lezzi, A. Baroni, M. Pasotti and P. L. Rolandi, "Power efficient charge pump in deep submicron standard CMOS technology," Proceedings of the 27th European Solid-State Circuits Conference, Villach, Austria, 2001, pp. 73-76.
- Jieh-Tsorng Wu and Kuen-Long Chang, "MOS charge pumps for low-voltage operation," in IEEE Journal of Solid-State Circuits, vol. 33, no. 4, pp. 592-597, April 1998, doi: 10.1109/4.663564.

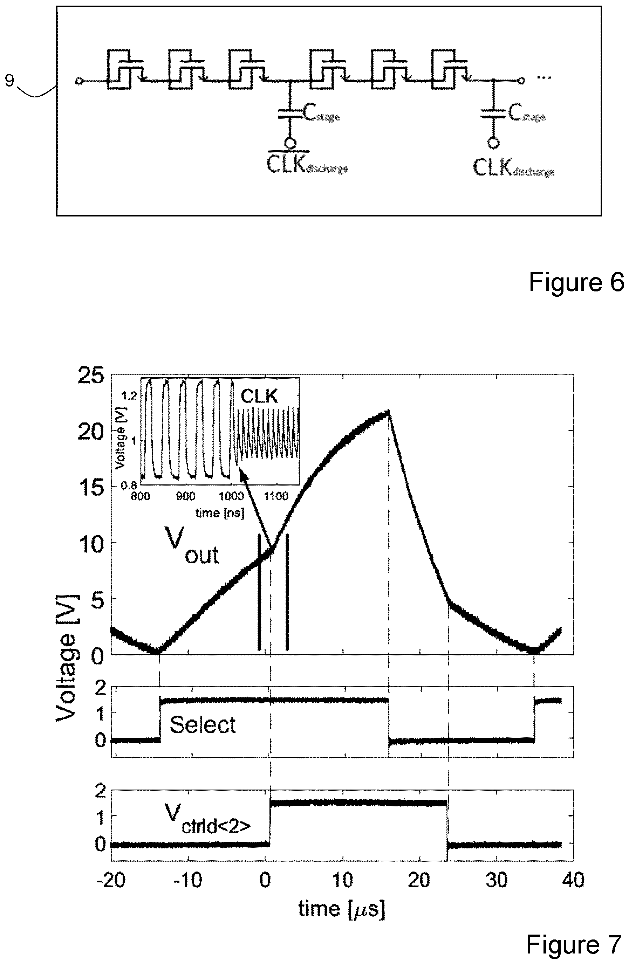

Figure 6 illustrates a particular embodiment of second charge pump 9, which is a 15-stage charge pump, of which only two stages have been illustrated. This again comprises a plurality of Dickson charge pump stages, implemented with three diode connected isolated thick oxide NMOS transistors and metal-insulator-metal (MiM) capacitors, driven by signals *CLK_{discharge}* and *CKL_{discharge}*. Other types of second charge pump 9 are of course possible, as mentioned above in the context of first charge pump 7.

The AWG 1 architecture described above can be implemented in an integrated form on a single chip using standard CMOS technology, while nevertheless permitting an output voltage *Vₒᵤₜ* exceeding 20 volts.

Figure 7 illustrates the principles of waveform generation in the AWG 1 of the invention. The rise or fall time of a charge pump 7, 9 depends on the frequency of *CLK,* therefore enabling one to tune the time-domain waveform by changing the clock frequency at pre-determined time points, as can be seen at the inflection point in *Vₒᵤₜ*, caused by the change of frequency in the signal *CLK.* By setting the digital control of the ring oscillator 3 by leans of input *V*_{ctrl_{d}}<2>, the frequency of *CLK* is adjusted, from approximately 43.5 MHz before the inflection point to 90.9 MHz after the inflection point, thus decreasing the waveform rise time. *'Select'* signal is switched to start the falling edge and the fall time is controlled in the same manner using the oscillator inputs, thus enabling arbitrary waveform generation up to more than 20V. The generated output *Vₒᵤₜ* is a continuous waveform with a period equal to the period of *'Select',* whose duty cycle also sets the highest and lowest output voltage *Vₒᵤₜ* values.

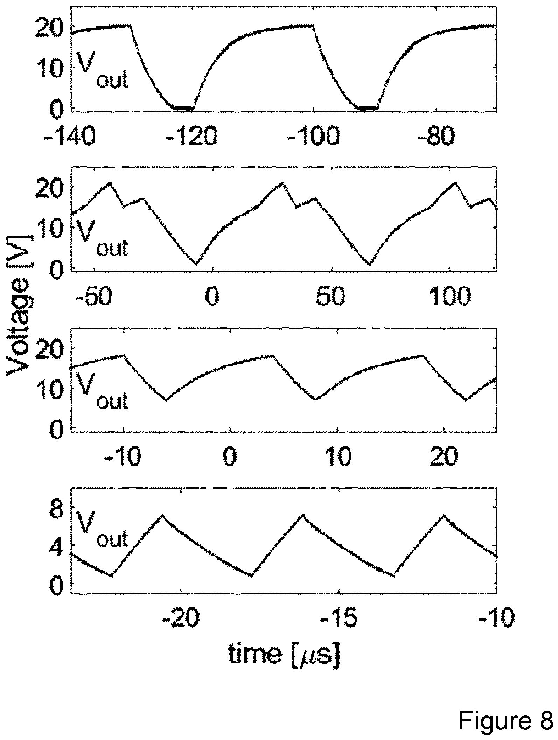

By operating the circuit with different oscillator control input sequences, waveforms with different shapes, amplitudes, frequencies and offset values can be produced, such as those illustrated by way of example in figure 8. For the measurements presented here, *Vₒᵤₜ* was fed to an external unity-gain voltage buffer whose output was measured. Load capacitance at chip output was measured at 26 pF. *Vᵢₙ* and *V_{cascode}* were biased at *V_{DD}*= 3.3V. Voltage steps of the output waveform were measured as ~5 mV, which corresponds to one clock cycle of the charge pump 7, 9.

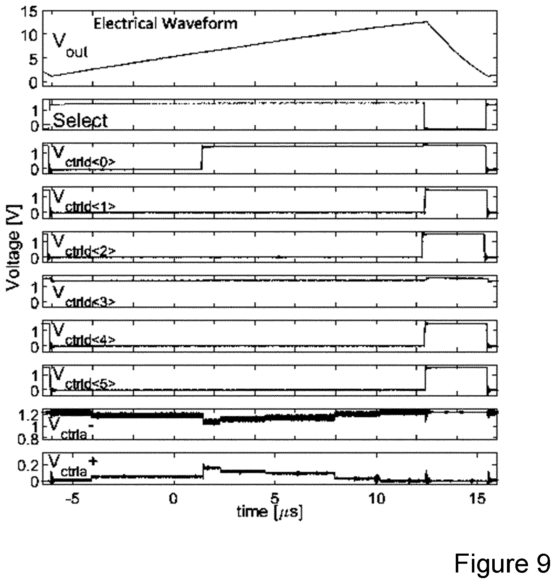

Figure 9 shows the relationship between the various control input voltages and *Vₒᵤₜ*, in order to generate a specific sawtooth wave profile useful for controlling the vernier laser of a FMCW LiDAR system. However, the AWG 1 of the invention can also be used to control ultrasound transducers, piezoactuators, neurostimulators, and many other devices.

Although the invention has been described in reference to specific embodiments, variations thereto are possible without departing from the scope of protection of the appended claims.

## Claims

1. High voltage arbitrary waveform generator (1) comprising:
- a voltage-controlled oscillator (3) arranged to output a clock signal *(CLK)* and an inverted clock signal (*C̅L̅K̅*) at a frequency determined by at least one control voltage (*V*_{ctrl_*a⁻*}, *V_{ctrl_a⁺}*, *V*_{ctrl_{d}}<5:0>);
- a first charge pump (7) arranged to receive said clock signal *(CLK)* and said inverted clock signal (*C̅L̅K̅*) and to increase an output voltage (*Vₒᵤₜ*) at an output node (10) in response to said clock signal *(CLK)* and said inverted clock signal (*C̅L̅K̅*);
- a second charge pump (9) arranged to receive said clock signal *(CLK)* and said inverted clock signal (*C̅L̅K̅*) and to decrease said output voltage (*Vₒᵤₜ*) at said output node (10) in response to said clock signal *(CLK)* and said inverted clock signal (*C̅L̅K̅*);
- a selector adapted transmit said clock signal *(CLK)* and said inverted clock signal (*C̅L̅K̅*) to either said first charge pump (7) or said second charge (9) pump at any given time in response to a select signal *(Select);*
- a load (*C_{L}*) connected between said output node (10) and ground.

2. High voltage arbitrary waveform generator (1) according to claim 1, wherein said voltage-controlled oscillator (3) is a voltage-controlled ring oscillator, preferably a voltage-controlled differential ring oscillator, further preferably a voltage-controlled differential ring oscillator with four stages.

3. High voltage arbitrary waveform generator (1) according to any preceding claim, wherein at least one of said charge pumps (7, 9) is a Dickson charge pump.

4. High voltage arbitrary waveform generator (1) according to the preceding claim, wherein said first charge pump (7) comprises between 8 and 13 Dickson charge pump stages, preferably 11 Dickson charge pump stages.

5. High voltage arbitrary waveform generator (1) according claim 3 or 4, wherein said second charge pump (9) comprises between 13 and 17 Dickson charge pump stages, preferably 15 Dickson charge pump stages.

6. High voltage arbitrary waveform generator (1) according to any preceding claim, further comprising a discharge transistor (11a) arranged to discharge said second charge pump (9) and controlled by said clock signal *(CLK)* as transmitted to said second charge pump (9), a cascode transistor (11) being arranged in series with said discharge transistor (11a) and biased by a cascode voltage (*V_{cascode}*).
